# EUROPEAN PATENT SPECIFICATION

(11) **EP 4 346 093 B1**
(45) Date of publication and mention of the grant of the patent: **18.12.2024**
(21) Application number: 23187476.9
(22) Date of filing: 25.07.2023
(51) Int. Cl.: H02S 30/20, H01L 31/048, H02S 40/34

(54) **PHOTOVOLTAIC MODULE AND METHOD FOR PREPARING THE SAME**
FOTOVOLTAISCHES MODUL UND VERFAHREN ZUR HERSTELLUNG DAVON
MODULE PHOTOVOLTAÏQUE ET SON PROCÉDÉ DE PRÉPARATION

(30) Priority: 30.09.2022 CN 202211214419
(43) Date of publication of application: 03.04.2024
(73) Proprietor: Jinko Solar (Haining) Co., Ltd., Haining City, Zhejiang 314416 (CN); Zhejiang Jinko Solar Co., Ltd., Haining, Zhejiang 314416 (CN)
(72) Inventor: LI, Ning, Haining City, 314416 (CN); XIAO, Pengjun, Haining City, 314416 (CN); DAI, Zhigang, Haining City, 314416 (CN); YANG, Sen, Haining City, 314416 (CN); GONG, Yuanqi, Haining City, 314416 (CN); LI, Bo, Haining City, 314416 (CN); YIN, Jiaxiang, Haining City, 314416 (CN); TAO, Chunhua, Haining City, 314416 (CN)
(74) Representative: Balder IP Law, S.L.

(56) References cited:
- CN-A- 106 449 835
- CN-U- 210 156 397
- US-A1- 2019 028 056
- US-A1- 2022 199 844
- SIM YEON HYANG ET AL: "Origami-foldable tessellated Crystalline-Si solar cell module with metal textile-based stretchable connections", SOLAR ENERGY MATERIALS AND SOLAR CELLS, ELSEVIER SCIENCE PUBLISHERS, AMSTERDAM, NL, vol. 231, 10 August 2021 (2021-08-10), XP086767153, ISSN: 0927-0248, [retrieved on 20210810], DOI: 10.1016/J.SOLMAT.2021.111318

## Description

### TECHNICAL FIELD

Embodiments of the present application relate to the technical field of solar cells, and in particular to a photovoltaic module, and a method for preparing a photovoltaic module.

### BACKGROUND

A photovoltaic module, also known as a solar panel, is configured to generate electricity through the "photovoltaic effect". The photovoltaic module is the core part of the solar power generation system. With the popularization of the policy of carbon peaking and carbon neutrality, environmentally friendly buildings have become the main theme of the industry. A foldable flexible photovoltaic module is used as a shade or a sun visor for building doors and windows, motorhomes, etc. In response to a flexible photovoltaic module being unfolded, the flexible photovoltaic module not only provides shelter, but also generates electricity. Due to the small occupied area after being folded, the foldable flexible photovoltaic module is easy to be stored, which makes the foldable flexible photovoltaic module increasingly popular.

However, at present, the photovoltaic module has poor folding performance. For example, in SIM YEON HYANG ET AL:"Origami-foldable tessellated Crystalline-Si solar cell module with metal textile-based stretchable connections" SOLAR ENERGY MATERIALS AND SOLAR CELLS, ELSEVIER SCIENCE PUBLISHERS, AMSTERDAM, NL, vol. 231, 10 August 2021 (2021-08-10), the increasing demand for photovoltaic (PV) electricity has resulted in wider usage for many applications. Current dominant PV electrical sources use crystalline silicon (c-Si) solar modules. These would provide greater potential as an energy source if they could be installed to any surface with a curvature, for example integration into buildings, and would perform better under omni-directional incident light, which is not considered in the design of current modules. In this study, we propose an1 origami-type foldable c-Si solar cell module by introducing a tessellated module design and textile-based woven metal connections to overcome the limitations of using c-Si solar cell modules on curved surfaces and under various light conditions. For the proposed module, two main concepts are introduced: a tessellation design for rigid folding and stretchable textile-based metal connections. The flexible crease pattern and interconnection allows the modules to be folded up to 180°, and a diagonal force on the metal textile can be induced on the inter-module connections using rotating wires. These features allow solar cell modules to cover an arbitrary surface without electrical degradation. Tessellating the module allows for maximum potential using the origami design when applied to both flat and curved surfaces. The origami-type foldable tessellated modules performed better than conventional modules. Their energy production under various angles of incident light is higher per day than that of flat modules, even during periods of lower intensity sunlight from a low solar altitude. These findings demonstrate a new approach to extend the usage of c-Si solar cells.

### SUMMARY

The embodiments of the present application provide a photovoltaic module and a method for preparing a photovoltaic module, which are at least beneficial for improving the folding performance of the photovoltaic module. The present invention is set out in the appended set of claims. The invention relates to a photovoltaic module set forth in claim 1 and to a method for preparing the same set forth in claim 14.

A photovoltaic module is provided according to the embodiments of the present application, the photovoltaic module includes multiple cell sheets arranged in an array including multiple rows and multiple columns, where each row of the multiple rows includes a set of cell sheets arranged at intervals along a first direction, each column of the multiple columns includes a set of cell sheets arranged at intervals along a second direction, and each cell sheet of the multiple cell sheets has a first surface and a second surface. The photovoltaic module further includes multiple support plates arranged at intervals, where each of the multiple support plates extends along the first direction or the second direction, and each of the multiple support plates is arranged on the second surface of each cell sheet of a respective row of the multiple rows or a respective column of the multiple columns of cell sheets. The photovoltaic module further includes a first flexible cover layer arranged on a side of the first surface of each of the multiple cell sheets, and a second flexible cover layer arranged on a side of the each of the multiple support plates away from the multiple cell sheets.

In some embodiments, each of the multiple support plates has a thickness of 20µm to 5000µm.

In some embodiments, the multiple support plates are in a one-to-one correspondence to the multiple columns of cell sheets or the multiple rows of cell sheets.

According to the invention, along a direction in which the multiple support plates are arranged, at least one of two outermost support plates is not provided with any of the multiple cell sheets on a surface of each of the two outermost support plates.

In some embodiments, a material of each of the multiple support plates includes either a metal material or a fiberglass composite material.

In some embodiments, two adjacent cell sheets in each of the multiple columns of cell sheets are connected in series, and each of the multiple columns of cell sheets is used to form a cell string.

In some embodiments, two adjacent cell strings are connected in series, and a distance between the two adjacent cell strings is 10mm to 200mm.

In some embodiments, the photovoltaic module further includes a busbar arranged on the first surface or the second surface of the cell sheet, where the busbar extends along the first direction, the busbar is configured to be electrically connected to two outermost two cell strings in which a positive electrode of one of the two outermost cell strings and a negative electrode of the other cell string are connected to the busbar, and the busbar is further configured to connect the two adjacent cell strings in series.

In some embodiments, two adjacent cell strings are connected in parallel, and a distance between the two adjacent cell strings is 10mm to 200mm.

In some embodiments, the photovoltaic module further includes a busbar arranged on the first surface or the second surface of the cell sheet, the busbar extends along the second direction, and the busbar is configured to be electrically connected to two outermost cell sheets in the cell string.

In some embodiments, a flexible welding strip configured to connect two adjacent cell sheets in series, where the flexible welding strip has a thickness of 50µm to 500µm

In some embodiments, the photovoltaic module further includes a first adhesive film and a second adhesive film, where the first adhesive film is arranged between the first flexible cover layer and the multiple cell sheets, and the second adhesive film is arranged between the multiple support plates and the multiple cell sheets.

Correspondingly, a method for preparing a photovoltaic module is further provided according to the embodiments of the present application, which is applied to any of the above photovoltaic modules, and the method includes providing multiple cell sheets, providing a second flexible cover layer; arranging multiple support plates at intervals on a surface of the second flexible cover layer, and laying the multiple cell sheets on the multiple support plates, whereby the multiple cell sheets are arranged in an array including multiple rows and multiple columns, each row of the multiple rows includes a set of cell sheets arranged at intervals along a first direction, each column of the multiple columns includes a set of cell sheets arranged at intervals along a second direction, and each respective row of the multiple rows of cell sheets or each respective column of the multiple columns of cell sheets is arranged on a surface of a respective support plate of the multiple support plates. The method further includes laying a first flexible cover layer on a surface of each of the multiple cell sheets.

### BRIEF DESCRIPTION OF THE DRAWINGS

One or more embodiments are described as examples with reference to the corresponding figures in the accompanying drawings, and the exemplary description does not constitute a limitation to the embodiments. The figures in the accompanying drawings do not constitute a proportion limitation unless otherwise stated.
FIG. 1 is a schematic structural view of a photovoltaic module provided according to an embodiment of the present application;
FIG. 2 is a schematic structural view of another photovoltaic module provided according to an embodiment of the present application;
FIG. 3 is a schematic circuit diagram of a photovoltaic module provided according to an embodiment of the present application;
FIG. 4 is a top view of a photovoltaic module provided according to an embodiment of the present application;
FIG. 5 is a schematic circuit diagram of another photovoltaic module provided according to an embodiment of the present application;
FIG. 6 is a top view of another photovoltaic module provided according to an embodiment of the present application; and
FIG. 7 is a schematic structural view of still another photovoltaic module provided according to an embodiment of the present application.

### DETAILED DESCRIPTION

It can be seen from the background technology that the folding performance of the photovoltaic module in the prior art is poor.

It is found in analysis that one of the reasons for the poor folding performance of the photovoltaic module is that in a foldable photovoltaic module in the prior art, one kind of the photovoltaic module is to replace only the cover plates arranged on two surfaces of the cell sheet with flexible front plates or flexible rear plates, so that the photovoltaic module is bent within the curvature radius of the flexible front plate and the flexible rear plate. However, the degree of bending of this kind of the photovoltaic module is limited and cannot be folded and stored. Another kind of foldable photovoltaic module mainly involves connecting two or more photovoltaic modules together through connecting components, and folding multiple photovoltaic modules up and down. However, this folding method cannot achieve folding within a single photovoltaic module, resulting in a relatively large volume of the folded photovoltaic module and difficult to be carried.

In the photovoltaic module provided according to the embodiments of the present application, the first flexible cover layer and the second flexible cover layer are arranged, so that the multiple cell sheets can be folded. Each of the multiple support plates is arranged on the second surface of each of the multiple rows of cell sheets or each of the multiple columns of cell sheets. On the one hand, the multiple support plates are configured to support the multiple cell sheets, and prevent the multiple cell sheet from breaking. On the other hand, in response to the photovoltaic module being folded, the photovoltaic module can be folded along a gap between adjacent support plates. That is, the folding between multiple cell sheets can be implemented by folding between adjacent support plates, which is conducive to the folding and storing of the photovoltaic module, to achieve folding within a single photovoltaic module, thereby improving the folding performance of the photovoltaic module.

The embodiments of the present application will be described in detail below with reference to the accompanying drawings. However, those of ordinary skill in the art can understand that, in various embodiment of the present application, many technical details are set forth in order to provide the reader with a better understanding of the present application. However, the technical solutions claimed in the present application may be realized even without these technical details and various changes and modifications based on the following embodiments.

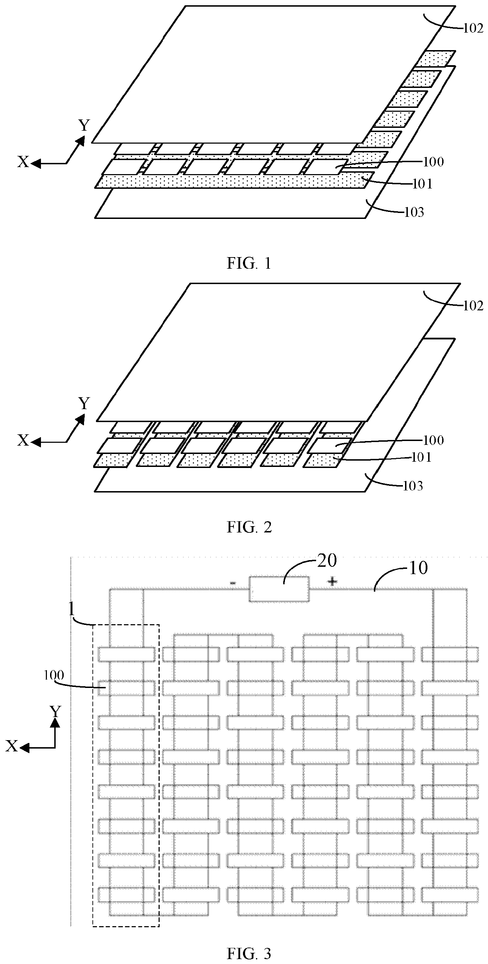

FIG. 1 is a schematic structural view of a photovoltaic module provided according to an embodiment of the present application. FIG. 2 is a schematic structural view of another photovoltaic module provided according to an embodiment of the present application.

Referring to FIG. 1 and FIG. 2, the photovoltaic module includes: multiple cell sheets 100 arranged in an array including multiple rows and multiple columns, where each row of the multiple rows includes a set of cell sheets 100 arranged at intervals along a first direction X, each column of the multiple columns includes a set of cell sheets 100 arranged at intervals along a second direction Y, and each cell sheet 100 of the multiple cell sheets 100 has a first surface and a second surface. The photovoltaic module further includes multiple support plates 101 arranged at intervals, where each of the multiple support plates 101 extends along the first direction X or the second direction Y, and each of the multiple support plates 101 is arranged on the second surface of each cell sheet 100 of a respective row of the multiple rows or a respective column of the multiple columns of cell sheets 100. The photovoltaic module further includes a first flexible cover layer 102 arranged on a side of the first surface of each of the multiple cell sheets 100, and a second flexible cover layer 103 arranged on a side of the each of the multiple support plates 101 away from the multiple cell sheets 100.

Each of the multiple cell sheets 100 is configured to absorb photons from incident light and generate electron hole pairs. The electron hole pairs are separated by the built-in electric field in the cell sheet 100, to generate potential at both ends of a PN junction, thereby converting light energy into electrical energy. In some embodiments, the first surface of the cell sheet 100 serves as the receiving surface for absorbing incident light. In other embodiments, both the first surface and the second surface of the cell sheet 100 serve as receiving surfaces for absorbing incident light. In some embodiments, the cell sheet 100 is a crystalline silicon solar cell, such as a monocrystalline silicon solar cell or a polycrystalline silicon solar cell. It can be understood that in some embodiments, the cell sheet 100 is a whole or multiple pieces (such as 1/2 equal pieces, 1/3 equal pieces, 1/4 equal pieces, etc.).

The first flexible cover layer 102 and the second flexible cover layer 103 are respectively arranged on two opposite surfaces of the cell sheet 100. The materials of the first flexible cover layer 102 and the second flexible cover layer 103 can be selected to have good flexibility, insulation, water resistance, and aging resistance. In this way, the first flexible cover layer 102 and the second flexible cover layer 103 can effectively protect and seal the cell sheet 100. Meanwhile, due to the good flexibility of the first flexible cover layer 102 and the second flexible cover layer 103, the entire photovoltaic module is easy to be folded.

Specifically, in some embodiments, the first flexible cover layer is a flexible cover plate. Each of the multiple support plates 101 is arranged on the second surface of each of the multiple cell sheets 100, so that each of the multiple support plates 101 not only supports and fixes the multiple cell sheets 100, but also provides protection for the multiple cell sheets 100. Due to the fact that the first flexible cover layer 102 is arranged on a side of the cell sheet 100 away from the surface of the support plate 101, in order to provide protection for the first surface of the cell sheet 100, it is possible to arrange the first flexible cover layer 102 to not only have flexibility but also have a certain degree of toughness, which can not only achieve the folding of the photovoltaic module, but also provide good protection for the first surface of the cell sheet 100. Specifically, in some embodiments, the flexible cover plate can be made of materials that are resistant to environmental aging and scratching, such as polyvinyl fluoride (PVF), polyvinylidene fluoride (PVDF), or ethylene tetrafluoroethylene (ETFE).

In some embodiments, the second flexible cover layer 103 is an insulating cloth. It can be understood that due to the fact that the second flexible cover layer 103 is arranged on the side of the support plate 101 away from the cell sheet 100, and each of the multiple support plates 101 has a relatively high hardness, so that the multiple support plates 101 have a good protective effect on the multiple cell sheets 100, that is, for the second surface of each of the multiple cell sheets 100, the multiple support plates 101 have already played a protective role. Based on this, in order to improve the flexibility of the photovoltaic module, the second flexible cover layer 103 is embodied as the insulation cloth. On the one hand, the insulating cloth can prevent the electricity leakage of the multiple cell sheets 100 and make the multiple cell sheets 100 to be functional. On the other hand, the insulating cloth has great flexibility, which can further improve the folding performance of the multiple cell sheets 100.

In addition, the second flexible cover layer 103 is embodied as an insulating cloth, and the light transmission performance of the insulating cloth can also be set to set the shading performance of the photovoltaic module. For example, in response to good shading performance being needed, the insulation cloth can be set with a darker color to block the incident light. In response to good transparency being needed, the insulation cloth can be set to have good transparency, so that after the photovoltaic module is unfolded, some of the incident light can pass through the gaps between adjacent cell sheets in the photovoltaic module.

A row of cell sheets 100 or a column of cell sheets 100 are arranged on the surface of each of the multiple support plates 101, and the cell sheets 100 are fixed on the surface of each of the multiple support plates 101. In some embodiments, the second surface of the cell sheet 100 and the surface of the support plate 101 can be fixed by adhesive. That is to say, each of the multiple support plates 101 serves as a support and fixation for a row of cell sheets 100 or a column of cell sheets 100. In this way, in response to the photovoltaic module being folded, it is only necessary to fold along the gap between adjacent support plates 101, so that two adjacent rows of cell sheets 100 or two adjacent columns of cell sheets 100 can be folded. In this way, the method for folding the photovoltaic module is similar to the method for folding louvers, thereby the photovoltaic module being enabled to be better applied as curtains on windows to meet the needs of users.

In addition, due to the large number of cell sheets 100 in the photovoltaic module, without the multiple support plates 101, it is likely to have cell sheets 100 being bent due to interfere happened in response to the photovoltaic module being folded, resulting in damage to the multiple cell sheets 100. The multiple support plates 101 allow the method for folding the photovoltaic module to be customized, that is, the photovoltaic module can be folded only along the gap between the two adjacent rows of cell sheets 100 or only along the gap between two adjacent columns of cell sheets 100m, which improves the folding performance of the multiple cell sheets 100 while keeping the multiple cell sheets 100 undamaged.

Specifically, referring to FIG. 1, in some embodiments, multiple support plates 101 are arranged at intervals along the second direction Y, each of the multiple support plate 101 extends along the first direction X, and each of the multiple support plates 101 is arranged on the second surface of each of the multiple rows of cell sheets 100.

Referring to FIG. 2, in other embodiments, multiple support plates 101 are arranged at intervals along the first direction X, each of the multiple support plate 101 extends along the second direction Y, and each of the multiple support plates 101 is arranged on the second surface of each of the multiple columns of cell sheets 100.

It can be understood that in response to photovoltaic module being folded, the photovoltaic module is folded along the gap between the two adjacent support plates 101, and a folding angle included in the two adjacent support plates 101 is of great significance to the folding angle of the entire photovoltaic module. In response to the thickness of the support plate 101 being too large, and folding one support plate 101 onto the surface of an adjacent support plate 101, side walls of the two adjacent support plates 101 are abutted against each other, resulting in a problem where the folding angle between the two adjacent support plates 101 cannot be further reduced. In addition, in response to the thickness of the support plate 101 being too small, it will not be able to provide good support and protection for the multiple cell sheets 100. Based on this, in some embodiments, each of the multiple support plates has a thickness of 20µmto 5000µm. For example, it may be 20µm to 50µm, 50µm to 200µm, 200µm to 500µm, 500µm to 850µm, 850µm to 1000µm, 1000µm to 1500µm, 1500µm to 2000µm, 2000µm to 2500µm, 2500µm to 3000µm, 3000µm to 3500µm, 3500µm to 4000µm, 4000µm to 4500µm, or 4500µm to 5000µm. Within this thickness range, on the one hand, the thickness of the support plate 101 is reduced, which can solve the problem where the two adjacent support plates 101 cannot be further folded due to side walls of the two adjacent support plates 101 being abutted against each other during the folding process of the photovoltaic module, thereby improving the folding performance of the photovoltaic module. On the other hand, within this range, the thickness of the support plate 101 is too small, which can also provide good support and protection for the multiple cell sheets 100 and improve the quality of the photovoltaic module.

In some embodiments, the multiple support plates are in a one-to-one correspondence to the multiple columns of cell sheets or the multiple rows of cell sheets. Specifically, in response to the multiple support plates 101 being arranged in the same way as multiple columns of cell sheets 100 being arranged, each of the multiple support plates 101 is arranged on the second surface of each column of cell sheets 100. In response to the multiple support plates 101 being arranged in the same way as multiple rows of cell sheets 100 being arranged, each of the multiple support plates 101 is arranged on the second surface of each row of cell sheets 100.

According to the invention, along a direction in which the multiple support plates 101 are arranged, at least one of two outermost support plates 101 is not provided with any of the multiple cell sheets 100 on a surface of each of the two outermost support plates 101. In some embodiments, in the multiple support plates 101 arranged at intervals, one of the two outermost support plates 101 is not provided with any of the multiple cell sheets 100 on the surface. In other embodiments, in the multiple support plates 101 arranged at intervals, two outermost support plates 101 are both not provided with any of the multiple cell sheets 100 on the surface. For example, in response to one support plate 101 is arranged on the second surface of a column of cell sheets 100, there is a distance between the outermost column of cell sheets 100 and the side edge of the photovoltaic module being equal to the width of one support plate 101, and the one support plate is not provided with any of the multiple cell sheets 100. That is, compared to a solution in which a cell sheet 100 is provided on the surface of each of the multiple support plates 101, at least one of two outermost support plates 101 is not provided with any of the multiple cell sheets 100 on a surface of each of the outermost support plates 101, which can decrease the number of cell sheets 100, and increase the distance between the outermost column of cell sheets 100 and the side edge of the photovoltaic module, thereby increasing the creepage distance of the photovoltaic module. It can be understood that the side edge of the photovoltaic module referred to here as a side edge of the photovoltaic module arranged opposite to the outermost row of cell sheets 100.

In addition, at least one of two outermost support plates 101 is not provided with any of the multiple cell sheets 100 on a surface of each of the outermost support plates 101, so that there is sufficient space for placing the junction box, which not only facilitates hiding the junction box, but also does not affect the overall integrity of the circuit, thereby ensuring the aesthetic appearance of the photovoltaic module.

In some embodiments, the material of each of the multiple support plates 101 includes either a metal material or a fiberglass composite material. The metal material and the fiberglass composite material have high hardness, which can provide good support for the multiple cell sheets 100.

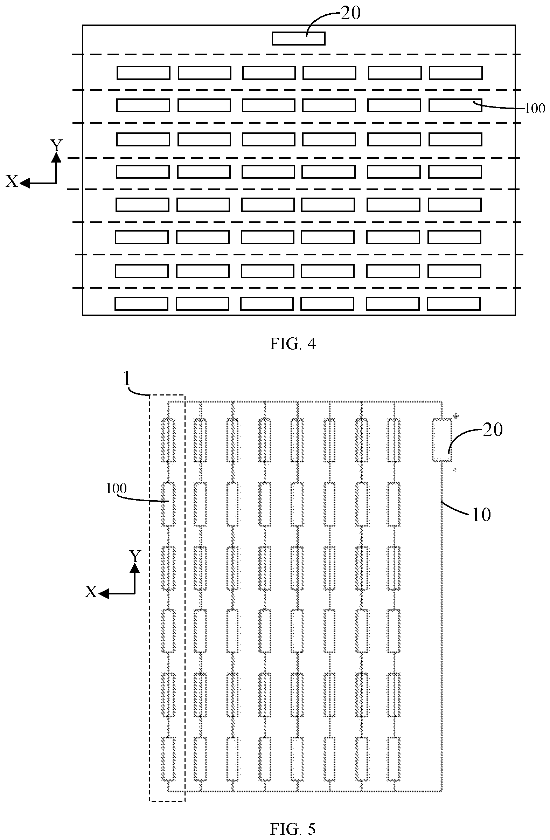

Referring to FIG. 3 and FIG. 5, in some embodiments, two adjacent cell sheets 100 in a column of cell sheets 100 are connected in series, and each column of cell sheets 100 is used to form a cell string 1 (shown in dashed boxes in FIG. 3 and FIG. 5). Specifically, in some embodiments, the photovoltaic module further includes: a flexible welding strip configured to connect two adjacent cell sheets 100 in series, and the flexible welding strip has a thickness of 50µm to 500µm. The flexible welding strip is arranged on the surface of the cell sheet 100. Specifically, the flexible welding strip is arranged can be arranged on the surface of a busbar of the cell sheet 100 and is configured to connect to two adjacent cell sheets 100, to achieve electrical connection between the two adjacent cell sheets 100. The flexible welding strip has good flexibility, which can achieve the folding of two adjacent cell sheets 100 in the cell string 1, while also maintaining the normal current transmission performance of the flexible welding strip.

In some embodiments, one end of the flexible welding strip is electrically connected to the first surface of the cell sheet 100, and the other end of the flexible welding strip is electrically connected to the second surface of an adjacent cell sheet 100 to form an electrical connection between the two cell sheets 100. In other embodiments, one end of the flexible welding strip is electrically connected to the first surface of a cell sheet 100, the other end of the flexible welding strip is electrically connected to the first surface of an adjacent cell sheet 100, or one end of the flexible welding strip is electrically connected to the second surface of a cell sheet 100, and the other end of the flexible welding strip is electrically connected to the second surface of an adjacent cell sheet 100 to form an electrical connection between adjacent cell sheets 100. In some embodiments, the shape of the flexible welding strip may be any of circular, rectangular, trapezoidal, or triangular. The flexible welding strip with the above shape has a larger thickness, which can improve the current transmission performance of the flexible welding strip.

It can be understood that in response to the flexible welding strip having a constant length, the thicker the flexible welding strip is, the harder to bend the flexible welding strip. The flexible welding strip has a thickness of 50µm to 500µm. Within the above thickness range, the flexible welding strip is not too thick to prevent the problem of folding between adjacent cell sheets 100 along the gap in a cell string, which limits the folding angle between adjacent cell sheets 100 due to the excessive thickness of the flexible welding strip. On the other hand, within this range, the thickness of the flexible welding strip is not too small, which can maintain the good current transmission performance of the flexible welding strip and improve the current collection capacity of the photovoltaic module. Specifically, in some embodiments, the flexible welding strip has a thickness of 50µm to 500µm. For example, it may be 50µm to 80µm, 80µm to 100µm, 100µm to 150µm, 150µm to 180µm, 180µm to 230µm, 230µm to 250µm, 280µm to 300µm, 300µm to 350µm, 350µm to 400µm, 400µm to 450µm, or 450µm to 500µm.

Referring to FIG. 3, in some embodiments, two adjacent cell strings are connected in series. That is to say, in the photovoltaic modules, all electrical connections between the multiple cell sheets 100 are series connection, that is, the circuit composed of multiple cell sheets 100 in the photovoltaic module is a series circuit. In some embodiments, adjacent cell strings can also be electrically connected by the flexible welding strips.

Referring to FIG. 3, in some embodiments, the photovoltaic module further includes a busbar 10 located on the first surface or the second surface of the cell sheet 100. Based on the series circuit formed by the multiple cell sheets 100 in the photovoltaic module, the busbar 10 extends along the first direction X. The busbar 10 is configured to be electrically connected to two outermost two cell strings in which a positive electrode of one of the two outermost cell strings and a negative electrode of the other cell string are connected to the busbar 10, and the busbar 10 is further configured to connect two adjacent cell strings in series. The positive electrode of a cell string refers to the input current end of the cell string, while the negative electrode of a cell string refers to the output current end of the cell string. One end of the current input in the cell string is located in the cell sheet 100 at the first stage, which can be the positive electrode of the cell sheet 100. One end of the current output in the cell string is located in the cell sheet 100 at the last stage, which can be the negative electrode of the cell sheet 100. The first stage refers to the cell sheet 100 in a cell string where the input end of the current is located, and the last stage refers to the cell sheet 100 in a cell string where the output end of the current is located. Specifically, each cell sheet 100 has an input end and an output end for current, that is, each cell sheet 100 has a positive electrode and a negative electrode. The negative electrode of a cell sheet 100 is electrically connected to the positive electrode of an adjacent cell sheet 100, to form a series circuit.

The busbar 10 extends in the first direction X, that is, the extension direction of the busbar 10 is the same as the direction in which the multiple cell strings are arranged, so that one end of the busbar 10 is electrically connected to one of the positive or negative electrodes arranged in one of the two outermost cell strings, and the other end of the busbar 10 is electrically connected to the other of the positive or negative electrodes arranged in the outermost cell string, thereby collecting the current of the entire circuit composed of cell sheets 100 in the photovoltaic module. Moreover, the two adjacent cell strings are electrically connected through a busbar to form a series circuit, and the busbar located between the two adjacent cell strings extends in the first direction X, to connect the first stage of one cell string and the last stage of the adjacent cell string, respectively.

It is not difficult to find that the busbar 10 extends along the first direction X, so that the extension direction of the busbar 10 is the same as the direction in which each row of cell sheets 100 is arranged. In order to prevent the busbar 10 from being folded, resulting in damage to the busbar 10 or breaking of the busbar 10 during folding the photovoltaic module, the extension direction of the multiple support plates 101 is set to be the same as the extension direction of the busbar 10. Therefore, in response to the photovoltaic module being folded along the gap between adjacent support plates 101, the busbar 10 will not be folded, which can prevent the busbar 10 from breaking. Reference is made to FIG. 4 for details, the dashed line in FIG. 4 represents the folding line of the photovoltaic module, which is folded along the folding line.

In addition, due to the fact that busbar 10 is not folded during the folding process of the photovoltaic module, in some embodiments, the busbar 10 is made of harder and thicker materials, which can ensure that busbar 10 has good current transmission performance and good current collection ability. In other embodiments, the busbar 10 may also be made of flexible materials.

It can be understood that in response to the photovoltaic module being folded, one row of cell sheets 100 is folded towards the adjacent row of cell sheets 100, or a column of cell sheets 100 is folded towards the adjacent row of cell sheets 100. That is to say, the two adjacent rows of cell sheets 100 are folded over each other or the two adjacent columns of cell sheets 100 are folded over each other. Therefore, it is necessary to set the thickness of each of the cell sheets 100 not to be too large to avoid the problem of the two adjacent rows of cell sheets 100 or adjacent two columns of cell sheets 100 being folded against each other, which causes the a side edge of a cell sheet to be abut against a side edge of an adjacent cell sheet 100 due to the excessive thickness of the cell sheets 100, makes it impossible for the photovoltaic module to be further folded, and makes the folding angle unable to be further reduced. Based on the above considerations, in some embodiments, the thickness of the cell sheet is 100µm to 170µm. For example, it may be 100µm to 110µm, 110µm to 120µm, 120µm to 130µm, 130µm to 140µm, 140µm to 150µm, 150µm to 160µm, or 160µm to 170µm. Within this range, the thickness of the cell sheets 100 is relatively small, which is beneficial for the formation of a lightweight photovoltaic module. In addition, within this range, the probability of a side edge of a cell sheet abutting against a side edge of an adjacent cell sheet 100 along a direction in which the two adjacent cell sheets are getting close to each other is reduced, so that the folding angle between two adjacent cell sheets 100 is relatively small, which is conducive to the storage of the photovoltaic module. In addition, within this range, the thickness of the cell sheet 100 is not too small, thereby ensuring the photoelectric conversion performance of the cell sheet 100.

In some embodiments, in response to two adjacent cell strings being connected in series, a distance between the two adjacent rows of cell sheets is 10mm to 200mm, for example, it may be 10mm to 30mm, 30mm to 50mm, 50mm to 70mm, 70mm to 100mm, 100mm to 130mm, 130mm to 150mm, 150mm to 180mm, or 180mm to 200mm. It can be understood that in response to the photovoltaic module being folded along the gap between two adjacent rows of cell sheets 100, the folding angle between the two adjacent rows of cell sheets 100 is related to the thickness of the cell sheets 100 and the distance between the two adjacent rows of cell sheets 100. In response to the two adjacent rows of cell sheets 100 being folded towards each other, and the distance between the two adjacent rows of cell sheets 100 being too small, the side edges of the adjacent rows of cell sheets 100 are abutted against each other. In addition, in response to the thickness of the cell sheet 100 being too large, it will also cause the side edges of the adjacent two cell sheets 100 to be abutted against each other, resulting in a problem where the folding angle between the adjacent two cell sheets 100 cannot be further reduced. In addition, in response to the photovoltaic module being folded along the gap between two adjacent support plates 101, it can be either two rows of cell sheets 100 folded over each other, that is, two rows of cell sheets 100 are folded to close to each other, or two support plates 101 are folded over each other, that is, two support plates 101 are folded towards each other to close to each other. Therefore, in response to the thickness of the support plate 101 being too large, side edges of the two adjacent support plates 101 getting close to each other are abutted against each other, resulting in the problem of the folding angle between the two support plates 101 being unable to be further reduced.

Based on the above considerations, the distance between two adjacent rows of cell sheets 100 is set to be within this range, so that the distance between two adjacent rows of cell sheets 100 matches the thickness of the cell sheets 100, and the distance between two adjacent rows of cell sheets 100 is sufficient to accommodate the total thickness of two stacked cell sheets 100, and thus the folding angle between adjacent two cell sheets 100 can reach 0 degree. In addition, the distance between the two adjacent rows of cell sheets 100 is enough to accommodate the total thickness of two stacked support plates, so that the folding angle between adjacent two cell sheets 100 can reach 0 degree, which greatly improves the folding performance and the storing performance of the photovoltaic module.

Referring to FIG. 5, in some embodiments, two adjacent cell strings are connected in parallel. That is to say, in the photovoltaic module, the electrical connection between the cell sheets 100 is a series-parallel connection. In some embodiments, two adjacent cell strings can be electrically connected by the flexible welding strip.

Referring to FIG. 5, in some embodiments, in response to two adjacent cell strings being connected in parallel, the busbar 10 extends along the second direction Y, and the busbar 10 is configured to electrically connect the two outermost cell sheets 100 in a cell string. The two outermost cell sheets 100 in a cell string serve as the current input and current output ends of the cell string, respectively. Among them, the cell sheet 100, which serves as the current input end, is in the first stage in the cell string, and the cell sheet 100, which serves as the current output end, is in the last stage in the cell string. That is to say, one end of busbar 10 is configured to electrically connect to the first stage of the cell string, and the other end of busbar 10 is configured to electrically connect to the last stage of the cell string, so that the busbar 10 can collect the current transmitted in each of the multiple cell strings. Specifically, the busbar 10 can only be electrically connected to the first stage and the last stage of the outermost cell string. In some embodiments, parallel connection can also be formed between two adjacent cell strings by the busbar 10, and the busbar 10 between adjacent cell strings extends along the second direction Y.

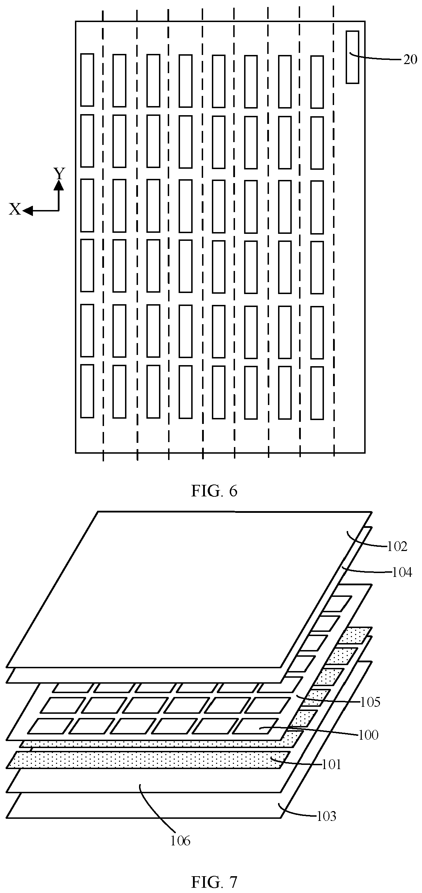

In response to two adjacent cell strings being connected in parallel, one support plate 101 can be arranged on the second surfaces of multiple cell sheets 100 in the cell string, so that the photovoltaic module is folded along the gap between two adjacent cell strings, which can prevent the problem of loss or even fracture of the busbar 10 during the folding process of the photovoltaic module. Reference is made to FIG. 6 for details. The dashed line in FIG. 6 represents the folding line of the photovoltaic module. That is, the photovoltaic module is folded along the folding line.

In some embodiments, in response to two adjacent cell strings being connected in parallel, the distance between the two adjacent columns of cell sheets is 10mm to 200mm. For example, it may be 10mm to 30mm, 30mm to 50mm, 50mm to 70mm, 70mm to 100mm, 100mm to 130mm, 130mm to 150mm, 150mm to 180mm, or 180mm to 200mm. Within this range, the distance between two adjacent columns of cell sheets 100 is matched with the thickness of the support plate 100, which makes the distance between two adjacent columns of cell sheets 100 sufficient to accommodate the total thickness of the two stacked cell sheets 100 to achieve a folding angle of 0 degree between adjacent two cell sheets 100. Moreover, the distance between the two adjacent columns of cell sheets 100 sufficient to accommodate the total thickness of the two support plates 101 after being stacked, to achieve a folding angle of 0 degree between the adjacent two support plates 101, thereby greatly improving the folding performance and the storing performance of the photovoltaic module.

In some embodiments, the photovoltaic module includes a central region and a peripheral region. The cell string is located in the central region, and the photovoltaic module further includes a junction box 20. The junction box 20 is located in the peripheral region of the photovoltaic module, and the junction box 20 is located on a side of the busbar 10 away from the cell string. The junction box 20 serves as a connecting device configured to connect the busbar 10 to external circuits and transport the current from the busbar 10 to external circuits. The junction box 20 in arranged in the peripheral region of the photovoltaic module, which makes it easy to combine the photovoltaic module with the window and hide the junction box 20 without affecting the integrity of the circuit.

Referring to FIG. 7, in some embodiments, the photovoltaic module further includes: a first adhesive film 104 and a second adhesive film 105. The first adhesive film 104 is arranged between the first flexible cover layer 102 and the multiple cell sheets 100, and the second adhesive film 105 is arranged between the multiple support plates 101 and the multiple cell sheets 100. The first adhesive film 104 and the second adhesive film 105 are configured to encapsulate the multiple cell sheets 100, and adhere the multiple cell sheets 100 to the first flexible cover layer 102, and adhere the multiple cell sheets 100 to the multiple support plates 101.

In some embodiments, the first adhesive film 104 and the second adhesive film 105 are at least one of a POE adhesive film or an EVA adhesive film. The POE adhesive film has excellent water vapor barrier and ion barrier capabilities, and does not produce acidic substances during aging. That is, the POE adhesive film has excellent anti-aging performance and anti-potential induced degradation (anti-PID) effect. The EVA adhesive film can facilitate the smooth passage of short wavelength incident light, thereby increasing the absorption and utilization of incident light by the cell sheet 100. In some embodiments, both the first adhesive film 104 and the second adhesive film 105 are POE adhesive films. In other embodiments, the first adhesive film 104 and the second adhesive film 105 are be EVA adhesive films. In some other embodiments, both the first adhesive film 104 and the second adhesive film 105 include POE materials and EVA materials. For example, the first adhesive film 104 and the second adhesive film 105 are composite adhesive films, which are composed of the POE adhesive film and the EVA adhesive film.

In other embodiments, the photovoltaic module further includes a third adhesive film 106 arranged between the multiple support plates 101 and the second flexible cover layer 103, and the third adhesive film 106 is configured to adhere the multiple support plates 101 to the insulating cloth. The material of the third adhesive film 106 can be the same as that of the second adhesive film 105 and the first adhesive film 104.

The overall thickness of the photovoltaic module also plays an important role in the folding performance of the photovoltaic module. In response to the overall thickness of the photovoltaic module being small, the thickness of the first flexible cover layer 102, the thickness of the first adhesive film 104, the thickness of the second adhesive film 105, and the thickness of the second flexible cover layer 103 are all relatively small, resulting in a smaller bending radius of the first flexible cover layer 102, the first adhesive film 104, the second adhesive film 105, and the second flexible cover layer 103, so that the overall bending resistance of the photovoltaic module is reduced, which is beneficial for bending the first flexible cover layer 102, the first adhesive film 104, the second adhesive film 105, and the second flexible cover layer 103 in the photovoltaic module, thereby improving the overall folding performance of the photovoltaic module. However, considering the sealing and protective effects of the first flexible cover layer 102, the first adhesive film 104, the second adhesive film 105, and the second flexible cover layer 103 on the photovoltaic module, it is necessary to ensure that the overall thickness of the photovoltaic module is not too small to provide sufficient space for the first flexible cover layer 102, the first adhesive film 104, the second adhesive film 105, and the second flexible cover layer 103. Based on this, in some embodiments, the overall thickness of the photovoltaic module is set to be 1mm to 10mm, for example, it may be 1mm to 2mm, 2mm to 3mm, 3mm to 4mm, 4mm to 5mm, 5mm to 6mm, 6mm to 7mm, 7mm to 8mm, 8mm to 9mm, or 9mm to 10mm. Within this thickness range, on the one hand, the overall thickness of the photovoltaic module is relatively small, resulting in a smaller thickness of the first flexible cover layer 102, the first adhesive film 104, the second adhesive film 105, and the second flexible cover layer 103, which is beneficial for reducing the bending resistance of the first flexible cover layer 102, the first adhesive film 104, the second adhesive film 105, and the second flexible cover layer 103, thereby integrally improving the folding performance of the photovoltaic module. On the other hand, within this range, the thickness of the first flexible cover layer 102, the first adhesive film 104, the second adhesive film 105, and the second flexible cover layer 103 is not too small, so that the first adhesive film 104 and the second adhesive film 105 provide sufficient adhering strength for the multiple cell sheets 100 and the first flexible cover layer 102, as well as the multiple cell sheets 100 and the multiple support plates 101, and can also have good water vapor barrier and ion barrier capabilities. The first flexible cover layer 102 and the second flexible cover layer 103 are enabled to provide good insulation and protection for the multiple cell sheets 100.

In the photovoltaic module provided according to the embodiments of the present application, the first flexible cover layer 102 and the second flexible cover layer 103 are arranged, so that the multiple cell sheets 100 can be folded. Each of the multiple support plates 101 is arranged on the second surface of each of the multiple rows of cell sheets 100 or each of the multiple columns of cell sheets 100. On the one hand, the multiple support plates 101 are configured to support the multiple cell sheets 100, and prevent the multiple cell sheets 100 from breaking. On the other hand, in response to the photovoltaic module being folded, the photovoltaic module can be folded along a gap between adjacent support plates 101. That is, the folding between multiple cell sheets 101 can be implemented by folding between adjacent support plates 101, which is conducive to the folding and storing of the photovoltaic module, to achieve folding within a single photovoltaic module, thereby improving the folding performance of the photovoltaic module.

Correspondingly, a method for preparing a photovoltaic module is further provided according to the embodiments of the present application, which is applied to any of the above photovoltaic modules, and the method includes providing multiple cell sheets 100, providing a second flexible cover layer 103, arranging multiple support plates 101 at intervals on a surface of the second flexible cover layer 103, and laying the multiple cell sheets 100 on the multiple support plates 101, whereby the multiple cell sheets 100 are arranged in an array including multiple rows and multiple columns, each row of the multiple rows includes a set of cell sheets 100 arranged at intervals along a first direction X, each column of the multiple columns includes a set of cell sheets 100 arranged at intervals along a second direction Y, and each respective row of the multiple rows of cell sheets 100 or each respective column of the multiple columns of cell sheets 100 is arranged on a surface of a respective support plate 101 of the multiple support plates 101. The method further includes laying a first flexible cover layer 102 on a surface of each of the multiple cell sheets 100.

In some embodiments, the second flexible cover layer 103 is an insulating cloth, which greatly improves the flexibility of the photovoltaic module.

Referring to FIG. 7, in some embodiments, multiple support plates 101 are adhered to the second flexible cover layer 103 by the third adhesive film 106. In order to improve the stability of the multiple support plates 101 on the surface of the second flexible cover layer 103, a high-temperature resistance adhesive tape is further arranged on the surface of each of the multiple support plates 101 facing towards the second flexible cover layer 103. The high-temperature adhesive resistance tape is configured to further fix the multiple support plates 101, and the third adhesive film 106 is further configured to adhere the high-temperature adhesive resistance tape to the multiple support plates 101.

In some embodiments, the multiple cell sheets 100 are adhered to the multiple support plates 101 by the second adhesive film 105. Firstly, a second adhesive film 105 is formed on the surface of each of the multiple support plates 101, and the multiple cell sheets 100 is laid on the surface of the second adhesive film 105. Multiple cell sheets 100 are laid on the surface of one of the multiple support plates 101. After the multiple cell sheets 100 are laid, the multiple cell sheets 100 located on the surface of the multiple support plates 101 are arranged in an array in which each row of cell sheets 100 arranged at intervals along the first direction X, and each column of cell sheets 100 arranged at intervals along the second direction Y.

In some embodiments, the multiple cell sheets 100 are adhered to the first flexible cover layer 102 by the first adhesive film 104. To begin with, the first adhesive film 104 is formed on the surface of each of the multiple cell sheets 100, and the multiple cell sheets 100 are laid on the surface of the second adhesive film 105. In some embodiments, the first flexible cover layer 102 is a flexible cover plate, so that the first flexible cover layer 102 not only has flexibility but also has a certain degree of toughness, thereby enabling the first flexible cover layer 102 to not only achieve the folding of the photovoltaic module, but also provide good protection for the first surface of each of the multiple cell sheets 100. Specifically, in some embodiments, the material of the flexible cover plate includes PVF, PVDF, or ETFE.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "has," "having," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

Although the present application is disclosed above with preferred embodiments, it is not used to limit the claims. The scope of protection shall be subject to the scope defined by the claims of the present application. In addition, the embodiments and the accompanying drawings in the specification of the present application are only illustrative examples, which will not limit the scope protected by the claims of the present application.

Those of ordinary skill in the art can understand that the above embodiments are specific examples for realizing the present application, and in actual disclosures, various changes may be made in shape and details without departing from the range of the present application. Any person skilled in the art can make their own changes and modifications without departing from the scope of the present application. Therefore, the protection scope of the present application should be subject to the scope defined by the claims.

## Claims

1. A photovoltaic module, comprising:
a plurality of cell sheets (100) arranged in an array comprising a plurality of rows and a plurality of columns, wherein each row of the plurality rows comprises a set of cell sheets (100) arranged at intervals along a first direction (X), each column of the plurality columns comprises a set of cell sheets (100) arranged at intervals along a second direction (Y), and each cell sheet of the plurality of cell sheets (100) has a first surface and a second surface;
a plurality of support plates (101) arranged at intervals, wherein each of the plurality of support plates (101) extends along the first direction (X) or the second direction (Y), and each of the plurality of support plates (101) is arranged on the second surface of each cell sheet (100) of a respective row of the plurality rows or a respective column of the plurality columns of cell sheets;
a first flexible cover layer (102) arranged on a side of the first surface of each of the plurality of cell sheets;
a second flexible cover layer (103) arranged on a side of the each of the plurality of support plates (101) away from the plurality of cell sheets (100);
**characterised in that** along a direction in which the plurality of support plates (101) are arranged, there is/are one or two additional outermost support plates which is/are not provided with any of the plurality of cell sheets (100) on its/their surface.

2. The photovoltaic module according to claim 1, wherein each of the plurality of support plates (101) has a thickness of 20µm to 5000µm.

3. The photovoltaic module according to claim 1 or 2, wherein the plurality of support plates (101) are in a one-to-one correspondence to the plurality columns of cell sheets (100) or the plurality rows of cell sheets (100).

4. The photovoltaic module according to claim 1, wherein in response to the photovoltaic module being folded, the photovoltaic module is folded along a gap between two adjacent support plates (101).

5. The photovoltaic module according to claim 1, wherein a material of each of the plurality of support plates (101) includes either a metal material or a fiberglass composite material.

6. The photovoltaic module according to claim 1, wherein two adjacent cell sheets in each of the plurality columns of cell sheets (100) are connected in series, and each of the plurality columns of cell sheets (100) is used to form a cell string.

7. The photovoltaic module according to claim 6, wherein two adjacent cell strings are connected in series, and a distance between the two adjacent cell strings is 10mm to 200mm.

8. The photovoltaic module according to claim 7, further including a busbar (10) arranged on the first surface or the second surface of the cell sheet (100), wherein the busbar (10) extends along the first direction (X), the busbar (10) is configured to be electrically connected to two outermost two cell strings in which a positive electrode of one of the two outermost cell strings and a negative electrode of the other cell string are connected to the busbar (10), and the busbar (10) is further configured to connect the two adjacent cell strings in series.

9. The photovoltaic module according to claim 6, wherein two adjacent cell strings are connected in parallel, and a distance between the two adjacent cell strings is 10mm to 200mm.

10. The photovoltaic module according to claim 9, further including a busbar (10) arranged on the first surface or the second surface of the cell sheet, the busbar (10) extends along the second direction (Y), and the busbar (10) is configured to be electrically connected to two outermost cell sheets (100) in the cell string.

11. The photovoltaic module according to claim 1, further including a flexible welding strip configured to connect two adjacent cell sheets in series, wherein the flexible welding strip has a thickness of 50µm to 500µm.

12. The photovoltaic module according to claim 1, further including a first adhesive film (104) and a second adhesive film (105), wherein the first adhesive film (104) is arranged between the first flexible cover layer (102) and the plurality of cell sheets (100), and the second adhesive film (105) is arranged between the plurality of support plates (101) and the plurality of cell sheets (100).

13. The photovoltaic module according to claim 12, wherein the first adhesive film (104) and the second adhesive film (105) are configured to encapsulate the plurality of cell sheets (100), the first adhesive film (104) is configured to adhere the plurality of cell sheets (100) to the first flexible cover layer (102), and the second adhesive film (105) is configured to adhere the plurality of cell sheets (100) to the second flexible cover layer (103).

14. A method for preparing a photovoltaic module, applied to the photovoltaic module according to any one of claims 1 to 13, the method comprising:
providing a plurality of cell sheets (100);
providing a second flexible cover layer (103);
arranging a plurality of support plates (101) at intervals on a surface of the second flexible cover layer (103);
laying the plurality of cell sheets (100) on the plurality of support plates (101), whereby the plurality of cell sheets are arranged in an array comprising a plurality of rows and a plurality of columns; each row of the plurality rows comprises a set of cell sheets arranged at intervals along a first direction (X), each column of the plurality columns comprises a set of cell sheets arranged at intervals along a second direction (Y), and each respective row of the plurality rows of cell sheets or each respective column of the plurality columns of cell sheets is arranged on a surface of a respective support plate of the plurality of support plates (101); and
laying a first flexible cover layer (102) on a surface of each of the plurality of cell sheets (100) .

## Patentansprüche

1. Photovoltaisches Modul, umfassend:
eine Vielzahl von Zelllagen (100), die in einem Array angeordnet sind, das eine Vielzahl von Reihen und eine Vielzahl von Spalten umfasst, wobei jede Reihe der Vielzahl von Reihen eine Menge von Zelllagen (100) umfasst, die in Intervallen entlang einer ersten Richtung (X) angeordnet sind, wobei jede Spalte der Vielzahl von Spalten eine Menge von Zelllagen (100) umfasst, die in Intervallen entlang einer zweiten Richtung (Y) angeordnet sind, und jede Zelllage der Vielzahl von Zelllagen (100) eine erste Oberfläche und eine zweite Oberfläche aufweist;
eine Vielzahl von Stützplatten (101), die in Intervallen angeordnet sind, wobei jede der Vielzahl von Stützplatten (101) sich entlang der ersten Richtung (X) oder der zweiten Richtung (Y) erstreckt, und jede der Vielzahl von Stützplatten (101) auf der zweiten Oberfläche jeder Zelllage (100) einer entsprechenden Reihe der Vielzahl von Reihen oder einer entsprechenden Spalte der Vielzahl von Spalten von Zelllagen angeordnet ist;
eine erste biegsame Abdeckungsschicht (102), die auf einer Seite der ersten Oberfläche von jeder der Vielzahl von Zelllagen angeordnet ist;
eine zweite biegsame Abdeckungsschicht (103), die auf einer Seite von jeder der Vielzahl von Stützplatten (101) weg von der Vielzahl von Zelllagen (100) angeordnet ist;
**dadurch gekennzeichnet, dass** entlang einer Richtung, in der die Vielzahl von Stützplatten (101) angeordnet sind, eine oder zwei zusätzliche äußerste Stützplatte/n vorhanden ist/sind, die nicht mit einer der Vielzahl von Zelllagen (100) auf ihrer Oberfläche versehen ist/sind.

2. Photovoltaisches Modul nach Anspruch 1, wobei jede der Vielzahl von Stützplatten (101) eine Dicke von 20 µm bis 5000 µm aufweist.

3. Photovoltaisches Modul nach Anspruch 1 oder 2, wobei die Vielzahl von Stützplatten (101) sich in einer Eins-zu-Eins-Entsprechung zu der Vielzahl von Spalten von Zelllagen (100) oder der Vielzahl von Reihen von Zelllagen (100) befinden.

4. Photovoltaisches Modul nach Anspruch 1, wobei als Reaktion auf das Falten des photovoltaischen Moduls das photovoltaische Modul entlang einer Lücke zwischen zwei benachbarten Stützplatten (101) gefaltet ist.

5. Photovoltaisches Modul nach Anspruch 1, wobei ein Werkstoff von jeder der Vielzahl von Stützplatten (101) entweder einen Metallwerkstoff oder einen Glasfaserverbundwerkstoff umfasst.

6. Photovoltaisches Modul nach Anspruch 1, wobei zwei benachbarte Zelllagen in jeder der Vielzahl von Spalten von Zelllagen (100) in Reihe geschaltet sind und jede der Vielzahl von Spalten von Zelllagen (100) zum Bilden eines Zellenstrangs verwendet wird.

7. Photovoltaisches Modul nach Anspruch 6, wobei zwei benachbarte Zellenstränge in Reihe geschaltet sind und ein Abstand zwischen den zwei benachbarten Zellensträngen 10 mm bis 200 mm beträgt.

8. Photovoltaisches Modul nach Anspruch 7, das ferner eine Sammelschiene (10) umfasst, die auf der ersten Oberfläche oder der zweiten Oberfläche der Zelllage (100) angeordnet ist, wobei die Sammelschiene (10) sich entlang der ersten Richtung (X) erstreckt, die Sammelschiene (10) dazu ausgestaltet ist, mit zwei äußersten Zellensträngen elektrisch verbunden zu sein, wobei eine Positivelektrode von einem der zwei äußersten Zellenstränge und eine Negativelektrode des anderen Zellenstrangs mit der Sammelschiene (10) verbunden sind und die Sammelschiene (10) ferner dazu ausgestaltet ist, die zwei benachbarten Zellenstränge in Reihe zu schalten.

9. Photovoltaisches Modul nach Anspruch 6, wobei zwei benachbarte Zellenstränge parallel geschaltet sind und ein Abstand zwischen den zwei benachbarten Zellensträngen 10 mm bis 200 mm beträgt.

10. Photovoltaisches Modul nach Anspruch 9, das ferner eine Sammelschiene (10) umfasst, die auf der ersten Oberfläche oder der zweiten Oberfläche der Zelllage angeordnet ist, wobei die Sammelschiene (10) sich entlang der zweiten Richtung (Y) erstreckt und die Sammelschiene (10) dazu ausgestaltet ist, mit zwei äußersten Zelllagen (100) in dem Zellenstrang elektrisch verbunden zu sein.

11. Photovoltaisches Modul nach Anspruch 1, das ferner ein biegsames Schweißband umfasst, das dazu ausgestaltet ist, zwei benachbarte Zelllagen in Reihe zu schalten, wobei das biegsame Schweißband eine Dicke von 50 µm bis 500 µm aufweist.

12. Photovoltaisches Modul nach Anspruch 1, das ferner eine erste Klebefolie (104) und eine zweite Klebefolie (105) umfasst, wobei die erste Klebefolie (104) zwischen der ersten biegsamen Abdeckungsschicht (102) und der Vielzahl von Zelllagen (100) angeordnet ist und die zweite Klebefolie (105) zwischen der Vielzahl von Stützplatten (101) und der Vielzahl von Zelllagen (100) angeordnet ist.

13. Photovoltaisches Modul nach Anspruch 12, wobei die erste Klebefolie (104) und die zweite Klebefolie (105) dazu ausgestaltet sind, die Vielzahl von Zelllagen (100) einzukapseln, wobei die erste Klebefolie (104) dazu ausgestaltet ist, die Vielzahl von Zelllagen (100) an die erste biegsame Abdeckungsschicht (102) zu kleben, und die zweite Klebefolie (105) dazu ausgestaltet ist, die Vielzahl von Zelllagen (100) an die zweite biegsame Abdeckungsschicht (103) zu kleben.

14. Verfahren zur Herstellung eines photovoltaischen Moduls, das auf das photovoltaische Modul nach einem der Ansprüche 1 bis 13 angewandt wird, wobei das Verfahren umfasst:
Bereitstellen einer Vielzahl von Zelllagen (100);
Bereitstellen einer zweiten biegsamen Abdeckungsschicht (103) ;
Anordnen einer Vielzahl von Stützplatten (101) in Intervallen auf einer Oberfläche der zweiten biegsamen Abdeckungsschicht (103);
Legen der Vielzahl von Zelllagen (100) auf die Vielzahl von Stützplatten (101), wodurch die Vielzahl von Zelllagen in einem Array angeordnet werden, das eine Vielzahl von Reihen und eine Vielzahl von Spalten umfasst; wobei jede Reihe der Vielzahl von Reihen eine Menge von Zelllagen umfasst, die in Intervallen entlang einer ersten Richtung (X) angeordnet werden, jede Spalte der Vielzahl von Spalten eine Menge von Zelllagen umfasst, die in Intervallen entlang einer zweiten Richtung (Y) angeordnet werden, und jede entsprechende Reihe der Vielzahl von Reihen von Zelllagen oder jede entsprechende Spalte der Vielzahl von Spalten von Zelllagen auf einer Oberfläche einer entsprechenden Stützplatte der Vielzahl von Stützplatten (101) angeordnet wird; und
Legen der ersten biegsamen Abdeckungsschicht (102) auf eine Oberfläche von jeder der Vielzahl von Zelllagen (100).

## Revendications

1. Module photovoltaïque comprenant :
une pluralité de feuilles de cellules (100) disposées en une matrice comprenant une pluralité de rangées et une pluralité de colonnes, dans laquelle chaque rangée parmi la pluralité de rangées comprend un jeu de feuilles de cellules (100) disposées à intervalles le long d'une première direction (X), chaque colonne parmi la pluralité de colonnes comprend un jeu de feuilles de cellules (100) disposées à intervalles le long d'une deuxième direction (Y), et chaque feuille de cellules parmi la pluralité de feuilles de cellules (100) a une première surface et une deuxième surface ;
une pluralité de plaques de support (101) disposées à intervalles, dans laquelle chacune parmi la pluralité de plaques de support (101) s'étend le long de la première direction (X) ou la deuxième direction (Y), et chacune parmi la pluralité de plaques de support (101) est disposée sur la deuxième surface de chaque feuille de cellules (100) d'une rangée respective parmi la pluralité de rangées ou d'une colonne respective parmi la pluralité de colonnes de feuilles de cellules ;
une première couche de couverture flexible (102) disposée sur un côté de la première surface de chacune parmi la pluralité de feuilles de cellules ;
une deuxième couche de couverture flexible (103) disposée sur un côté de chacune parmi la pluralité de plaques de support (101) à distance de la pluralité de feuilles de cellules (100) ;
**caractérisé en ce que**, le long d'une direction dans laquelle la pluralité de plaques de support (101) sont disposées, il y a une ou deux plaques de support les plus extérieures additionnelles qui ne sont dotées d'aucune quelconque parmi la pluralité de feuilles de cellules (100) sur leur surface.

2. Module photovoltaïque selon la revendication 1, dans lequel chacune parmi la pluralité de plaques de support (101) a une épaisseur de 20 µm à 5000 µm.

3. Module photovoltaïque selon la revendication 1 ou 2, dans lequel la pluralité de plaques de support (101) sont en correspondance d'une pour une avec la pluralité de colonnes de feuilles de cellules (100) ou la pluralité de rangées de feuilles de cellules (100).

4. Module photovoltaïque selon la revendication 1, dans lequel, en réponse au pliage du module photovoltaïque, le module photovoltaïque est plié le long d'un espace entre deux plaques de support adjacentes (101).

5. Module photovoltaïque selon la revendication 1, dans lequel un matériau de chacune parmi la pluralité de plaques de support (101) comprend soit un matériau métallique soit un matériau composite de fibres de verre.

6. Module photovoltaïque selon la revendication 1, dans lequel deux feuilles de cellules adjacentes dans chacune parmi la pluralité de colonnes de feuilles de cellules (100) sont connectées en série, et chacune parmi la pluralité de colonnes de feuilles de cellules (100) est utilisée pour former une chaîne de cellules.

7. Module photovoltaïque selon la revendication 6, dans lequel deux chaînes de cellules adjacentes sont connectées en série, et la distance entre les deux chaînes de cellules adjacentes est de 10 mm à 200 mm.

8. Module photovoltaïque selon la revendication 7, comprenant en outre une barre omnibus (10) disposée sur la première surface ou la deuxième surface de la feuille de cellules (100), dans lequel la barre omnibus (10) s'étend le long de la première direction (X), la barre omnibus (10) est configurée pour être électriquement connectée à deux chaînes de cellules les plus extérieures dans lesquelles une électrode positive de l'une des deux chaînes de cellules les plus extérieures et une électrode négative de l'autre chaîne de cellules sont connectées à la barre omnibus (10), et la barre omnibus (10) est en outre configurée pour connecter les deux chaînes de cellules adjacentes en série.

9. Module photovoltaïque selon la revendication 6, dans laquelle deux chaînes de cellules adjacentes sont connectées en parallèle, et la distance entre les deux chaînes de cellules adjacentes est de 10 mm à 200 mm.

10. Module photovoltaïque selon la revendication 9, comprenant en outre une barre omnibus (10) disposée sur la première surface ou la deuxième surface de la feuille de cellules, la barre omnibus (10) s'étendant le long de la deuxième direction (Y), et la barre omnibus (10) étant configurée pour être électriquement connectée aux deux feuilles de cellules les plus extérieures (100) dans la chaîne de cellules.

11. Module photovoltaïque selon la revendication 1, comprenant en outre une bande de soudure flexible configurée pour connecter deux feuilles de cellules adjacentes en série, dans lequel la bande de soudure flexible a une épaisseur de 50 µm à 500µm.

12. Module photovoltaïque selon la revendication 1, comprenant en outre un premier film adhésif (104) et un deuxième film adhésif (105), dans lequel le premier film adhésif (104) est disposé entre la première couche de couverture flexible (102) et la pluralité de feuilles de cellules (100), et le deuxième film adhésif (105) est disposé entre la pluralité de plaques de support (101) et la pluralité de feuilles de cellules (100) .

13. Module photovoltaïque selon la revendication 12, dans lequel le premier film adhésif (104) et le deuxième film adhésif (105) sont configurés pour encapsuler la pluralité de feuilles de cellules (100), le premier film adhésif (104) est configuré pour faire adhérer la pluralité de feuilles de cellules (100) à la première couche de couverture flexible (102), et le deuxième film adhésif (105) est configuré pour faire adhérer la pluralité de feuilles de cellules (100) à la deuxième couche de couverture flexible (103).

14. Procédé pour préparer un module photovoltaïque, appliqué au module photovoltaïque de l'une quelconque des revendications 1 à 13, le procédé comprenant :
la fourniture d'une pluralité de feuilles de cellules (100) ;
la fourniture d'une deuxième couche de couverture flexible (103) ;
la disposition d'une pluralité de plaques de support (101) à intervalles sur une surface de la deuxième couche de couverture flexible (103) ;
la pose de la pluralité de feuilles de cellules (100) sur la pluralité de plaques de support (101), moyennant quoi la pluralité de feuilles de cellules sont disposées en une matrice comprenant une pluralité de rangées et une pluralité de colonnes ; chaque rangée parmi la pluralité de rangées comprend un jeu de feuilles de cellules disposées à intervalles le long d'une première direction (X), chaque colonne parmi la pluralité de colonnes comprend un jeu de feuilles de cellules disposées à intervalles le long d'une deuxième direction (Y), et chaque rangée respective parmi la pluralité de rangées de feuilles de cellules ou chaque colonne respective parmi la pluralité de colonnes de feuilles de cellules est disposée sur une surface d'une plaque de support respective parmi la pluralité de plaques de support (101) ; et
la pose d'une première couche de couverture flexible (102) sur une surface de chacune parmi la pluralité de feuilles de cellules (100).
